# EUROPEAN PATENT APPLICATION

(11) **EP 4 819 254 A1**
(43) Date of publication of application: **07.10.2026**
(21) Application number: 26158161.5
(22) Date of filing: 12.02.2026
(51) Int. Cl.: H01M 8/0213, H01M 8/0228, H01M 8/0206

(54) **SEPARATOR FOR FUEL CELL AND METHOD OF MANUFACTURING SEPARATOR FOR FUEL CELL**

(30) Priority: 31.03.2025 JP 2025057461
(71) Applicant: Toyota Jidosha Kabushiki Kaisha, Toyota-shi, Aichi-ken 471-8571 (JP)
(72) Inventor: SAKURAI, Kohei, Toyota-shi, 471-8571 (JP); NOMOTO, Shigemitsu, Toyota-shi, 471-8571 (JP); ODA, Tohru, Toyota-shi, 471-8571 (JP)
(74) Representative: Kuhnen & Wacker Patent- und Rechtsanwaltsbüro PartG mbB

(57) **Abstract**

A separator for a fuel cell comprises: a metallic base material; a titanium-based layer stacked in a stacking direction with respect to the base material; and a carbon layer stacked on an opposite side to the base material with respect to the titanium-based layer in the stacking direction. The titanium-based layer includes a titanium metal layer. The carbon layer includes: a first carbon layer; and a second carbon layer stacked on the opposite side to the base material with respect to the first carbon layer in the stacking direction. The second carbon layer contains at least one type from a hydrogen element, a nitrogen element, and an oxygen element as a minor element.

## Description

### BACKGROUND

### FIELD

The present disclosure relates to a separator for a fuel cell, and a method of manufacturing a separator for a fuel cell.

### RELATED ART

In relation to a separator for fuel cell, Japanese Patent Application Publication No. 2021-93298 discloses a separator including a titanium metal layer arranged in a surface layer part of a metallic base material, and an electrically-conductive carbon layer arranged in a surface layer part of the separator.

Deterioration of an electrolyte membrane associated with use of a fuel cell is known to generate impurity derived from the electrolyte membrane. Such impurity might cause peeling of the carbon layer from the separator.

### SUMMARY

The present disclosure is feasible in the following aspects.
(1) According to a first aspect of the present disclosure, a separator for a fuel cell is provided. The separator comprises: a metallic base material; a titanium-based layer stacked in a stacking direction with respect to the base material; and a carbon layer stacked on an opposite side to the base material with respect to the titanium-based layer in the stacking direction. The titanium-based layer includes a titanium metal layer. The carbon layer includes: a first carbon layer; and a second carbon layer stacked on the opposite side to the base material with respect to the first carbon layer in the stacking direction. The second carbon layer contains at least one type from a hydrogen element, a nitrogen element, and an oxygen element as a minor element.
   According to this aspect, by providing the second carbon layer with at least one type from the hydrogen element, the nitrogen element, and the oxygen element as the minor element, it becomes possible for the second carbon layer to function as a barrier layer for suppressing penetration of generated water containing impurity derived from an electrolyte membrane of the fuel cell into the carbon layer. This makes it possible to reduce the occurrence of peeling of the carbon layer resulting from the impurity.
(2) In the above aspect, the second carbon layer may have a content of the minor element equal to or greater than 5 at.% and equal to or less than 30 at.%. According to this aspect, it is possible to effectively suppress degradation in the electrical conductivity of the second carbon layer resulting from the minor element while the second carbon layer is caused to fulfill the function as the barrier layer effectively.
(3) In the above aspect, the titanium-based layer may further include: a titanium carbide layer stacked between the titanium metal layer and the first carbon layer in the stacking direction; and a titanium oxide layer stacked between the titanium carbide layer and the first carbon layer in the stacking direction. According to this aspect, the titanium oxide layer is allowed to function as a protective layer for protecting the titanium-based layer from oxidation resulting from the impurity derived from the electrolyte membrane. This makes it possible to suppress oxidation of the titanium-based layer resulting from the impurity. Thus, it is possible to reduce the occurrence of degradation in binding property between the titanium element in the titanium-based layer and a carbon element in the carbon layer resulting from oxidation of the titanium carbide layer. As a result, it is possible to reduce the occurrence of peeling of the carbon layer more effectively.
(4) In the above aspect, the titanium oxide layer may have a thickness equal to or greater than 1 nm and equal to or less than 15 nm. According to this aspect, it is possible to suppress degradation in the electrical conductivity of the separator for fuel cell resulting from increase in the thickness of the titanium oxide layer while the titanium oxide layer is caused to fulfill the function as the protective layer favorably.
(5) According to a second aspect of the present disclosure, a method of manufacturing a separator for a fuel cell is provided. The manufacturing method comprises: a preparatory step of preparing a stack including a metallic base material, a titanium-based layer, and a first carbon layer, the titanium-based layer being stacked in a stacking direction with respect to the base material and including a titanium metal layer, the first carbon layer being stacked on an opposite side to the base material with respect to the titanium-based layer in the stacking direction; and a forming step of forming a second carbon layer on the opposite side to the base material with respect to the first carbon layer in the stacking direction by ion plating using a vapor deposition source containing a carbon element. The second carbon layer contains at least one type from a hydrogen element, a nitrogen element, and an oxygen element as a minor element. In the forming step, at least one type from the hydrogen element, the nitrogen element, and the oxygen element is provided in at least one of the vapor deposition source and an atmosphere for ionizing the vapor deposition source.

In addition to the aspects as the separator and the method of manufacturing the separator, the present disclosure is also feasible in aspects including a fuel cell and a method of manufacturing a fuel cell.

### BRIEF DESCRIPTION OF THE DRAWINGS

Fig. 1 is an explanatory view showing a schematic configuration of a fuel cell;
Fig. 2 is a plan view of a separator;
Fig. 3 is a sectional view along III-III in Fig. 2;
Fig. 4 is a flowchart showing a method of manufacturing the separator;
Fig. 5 is a view explaining the method of manufacturing the separator; and
Fig. 6 is a flowchart of a preparatory step.

### DETAILED DESCRIPTION

### A. Embodiment

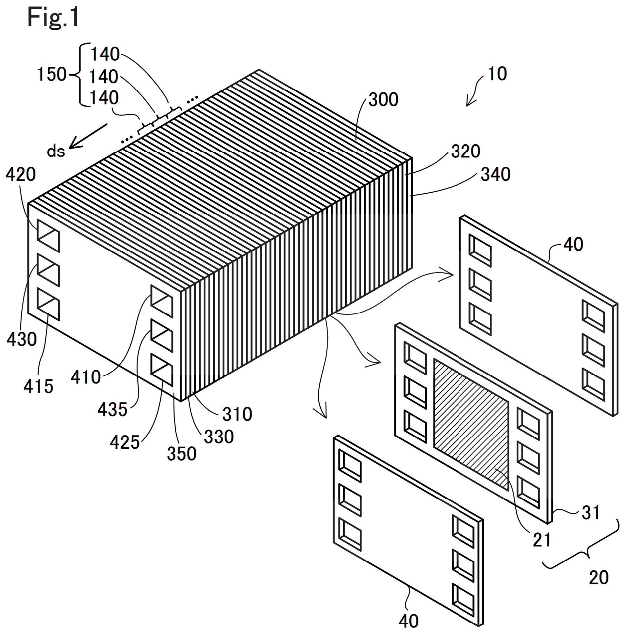

Fig. 1 is an explanatory view showing a schematic configuration of a fuel cell 10 according to the present embodiment. The fuel cell 10 includes a cell stack 150, terminal plates 300 and 310 in a pair, insulating plates 320 and 330 in a pair, and end plates 340 and 350 in a pair. The cell stack 150 is composed of a plurality of unit cells 140 stacked in a direction ds. The direction ds is a direction perpendicular to a plane direction of the unit cell 140 having a plate-like shape. The terminal plates 300 and 310 interpose the cell stack 150 therebetween in a Z direction. The insulating plates 320 and 330 are arranged in contact with the terminal plates 300 and 310 respectively from outside in the Z direction. The end plates 340 and 350 are arranged in contact with the insulating plates 320 and 330 respectively from outside in the Z direction. The fuel cell 10 is fastened in the direction ds by a fastening member not shown in the drawings to be formed into a stack.

The fuel cell 10 is a solid polymer fuel cell that generates electricity in response to supply of an anode gas containing hydrogen and a cathode gas containing oxygen. Electricity generated in the fuel cell 10 by electrochemical reaction is collected at the terminal plates 300 and 310, and is extracted to an external load from terminals provided at the terminal plates 300 and 310.

As shown in Fig. 1, the fuel cell 10 includes an anode gas supply manifold 410 for supplying the anode gas to the fuel cell 10, and an anode gas discharge manifold 415 for discharging the anode gas from the fuel cell 10. Likewise, the fuel cell 10 includes a cathode gas supply manifold 420 and a cathode gas discharge manifold 425 for supplying and discharging the cathode gas respectively, and a cooling medium supply manifold 430 and a cooling medium discharge manifold 435 for supplying and discharging a cooling medium respectively. Each manifold is configured to penetrate the end plate 350, the insulating plate 330, the terminal plate 310, and all the stacked unit cells 140.

Each unit cell 140 includes a membrane electrode gas-diffusion-layer assembly (MEGA) plate 20, and separators 40 in a pair. The MEGA plate 20 includes a MEGA 21 and a resin sheet 31 joined to a periphery of the MEGA 21.

The MEGA 21 includes a membrane electrode assembly (MEA), and gas diffusion layers in a pair interposing the MEA therebetween. The MEA includes an electrolyte membrane, and an anode electrode catalyst layer and a cathode electrode catalyst layer arranged on corresponding surfaces of the electrolyte membrane opposite to each other. The electrolyte membrane is a solid polymer membrane exhibiting favorable proton conductivity in a wet state. The electrolyte membrane is composed of an ion exchange membrane made of fluorine resin, for example. The catalyst layers include catalysts for facilitating chemical reaction between hydrogen and oxygen, and carbon particles on which the catalysts are supported. The gas diffusion layers are provided adjacent to surfaces on the sides of the corresponding catalyst layers. The gas diffusion layers are layers for causing the reaction gases used for the electrode reaction to diffuse in a plane direction of the electrolyte membrane, and are composed of porous base materials for diffusion layers. As the base materials for diffusion layers, porous base materials having electrical conductivity and gas diffusion properties are used that are carbon fiber base materials, graphitic fiber base materials, or foamed metal, for example.

In the present embodiment, the resin sheet 31 is composed of polyethylene terephthalate (PET). In other embodiments, the resin sheet 31 may be composed of members of various types of other thermoplastic resins such as polypropylene and polyethylene. The resin sheet 31 includes a slit-like gas inlet channel (not shown in the drawings) provided in such a way as to connect each manifold and the MEGA 21 to each other. The gas inlet channel is formed in such a way as to penetrate the resin sheet 31, for example.

The separators 40 in a pair interpose the MEGA plate 20 therebetween in the direction ds. In the fuel cell 10, the separator 40 serves the function of ensuring a gas flow path in the unit cell 140 while separating the unit cells 140 from each other, a function for collecting electricity generated in each unit cell 140 using the electrical conductivity of the separator 40, and others. The separator 40 corresponds to a "separator for a fuel cell" of the present disclosure,

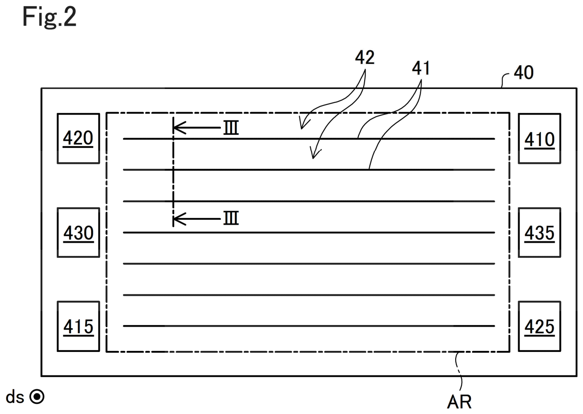

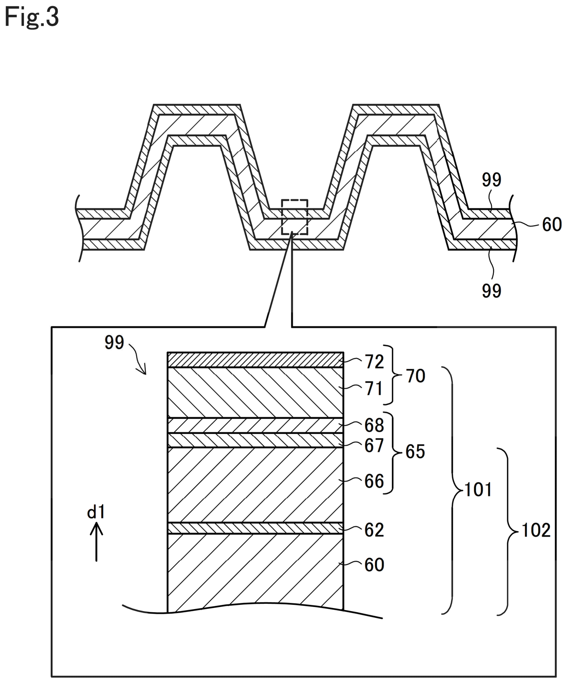

Fig. 2 is a plan view of the separator 40. Fig. 3 is a sectional view along III-III in Fig. 2. A dashed-line part of the separator 40 in an upper section of Fig. 3 is shown in an enlarged manner in a lower section of Fig. 3. As shown in Fig. 2, the separator 40 has a rectangular plate-like appearance shape. The separator 40 has manifold holes for the corresponding manifolds in the fuel cell 10. Each manifold hole is formed appropriately at a position located at each end portion of the separator 40 in a longitudinal direction thereof and conforming to a corresponding manifold.

The separator 40 includes a gas flow path 42 formed at a position conforming to the gas inlet channel and defined by a plurality of grooves 41 like projections and recesses. The gas flow path 42 is provided in a flow path region AR in the separator 40. In the longitudinal direction of the separator 40, the flow path region AR is located internal to each manifold hole arranged at each end portion of the separator 40. Gas flowing in each manifold is supplied to the MEGA 21 via the gas inlet channel and the gas flow path 42. The grooves 41 and the gas flow path 42 are omitted from Fig. 1.

As shown in Fig. 3, the separator 40 has a stacked structure with a plurality of stacked layers. The separator 40 includes a base material 60, a transition layer 62, a titanium-based layer 65, and a carbon layer 70. The carbon layer 70 includes a first carbon layer 71 and a second carbon layer 72. The titanium-based layer 65 includes at least a titanium metal layer 66. In the present embodiment, the titanium-based layer 65 further includes a titanium carbide layer 67 and a titanium oxide layer 68.

A direction in which the layers are stacked in the separator 40 is also called a stacking direction d1. The stacking direction d1 has an upper side and a lower side. The base material 60 is located at a lowermost side of the stacking direction d1. Specifically, the layers in the separator 40 other than the base material 60 are stacked on the upper side with respect to the base material 60 in the stacking direction d1. In the following, the upper side and the lower side of the stacking direction d1 will also be called an "upper side" and a "lower side" simply. In the separator 40, the base material 60, the transition layer 62, the titanium metal layer 66, the titanium carbide layer 67, the titanium oxide layer 68, the first carbon layer 71, and the second carbon layer 72 are stacked in this order as viewed from the lower side toward the upper side of the stacking direction d1.

The layers stacked on the base material 60 will also be called an upper layer 99 collectively. The upper layer 99 has the function of suppressing corrosion of the base material 60 resulting from generated water while ensuring the electrical conductivity of the separator 40. The generated water is generated by electrochemical reaction on a cathode side of the unit cell 140. The generated water generated on the cathode side may move toward an anode side across the MEGA 21. Such generated water might contain impurity derived from the electrolyte membrane of the MEGA 21. The impurity mentioned herein is a fluorine compound such as hydrogen fluoride or a sulfonic acid-based compound having a sulfonic acid group, for example, to be generated by deterioration of the electrolyte membrane associated with use of the fuel cell 10. Such impurity reduces a pH in the generated water and increases the corrosiveness of the generated water. The impurity derived from the electrolyte membrane is also called a deterioration product.

In the present embodiment, the upper layer 99 is provided on each surface of the separator 40. In other embodiments, the upper layer 99 may be provided only on one surface of the separator 40. In this case, the upper layer 99 is preferably provided at least on a surface of the separator 40 facing the gas diffusion layer, specifically, on a surface facing the MEGA 21.

In the present embodiment, the upper layer 99 is provided in an entire area of the flow path region AR. In other embodiments, the upper layer 99 may be provided only in a partial area of the flow path region AR. In this case, the upper layer 99 is preferably provided at least in a part in the vicinity of a manifold hole corresponding to the cathode gas supply manifold 420 (this part will be called a cathode gas inlet part). Reason for this is that, as the generated water is generated more easily and condensation of the generated water occurs more easily in the cathode gas inlet part, a measure against corrosion resulting from the generated water is more desirably taken in the cathode gas inlet part. More specifically, in the cathode gas inlet part, an oxidizing gas tends to exist in a comparatively large amount and the electrochemical reaction tends to proceed at a comparatively high reaction speed. This makes it likely that a larger amount of the generated water will be generated. Furthermore, in the cathode gas inlet part, moisture in the generated water is vaporized by the cathode gas to increase the probability of condensation of the generated water. The condensation of the generated water increases the concentration of the impurity in the generated water further to develop the corrosiveness of the generated water further.

The base material 60 is made of metal. In the present embodiment, the base material 60 is made of stainless steel (SUS). Compared to a case of forming the base material 60 using a titanium (Ti) material, forming the base material 60 using SUS allows the separator 40 to be manufactured at low cost.

The titanium metal layer 66 is stacked in the stacking direction d1 with respect to the base material 60. More specifically, the titanium metal layer 66 is stacked on the upper side with respect to the base material 60. The titanium metal layer 66 contains Ti as a major component. In the present disclosure, the major component means a component contained in a material, member or the like at a percentage equal to or greater than 50% by mass, more preferably, equal to or greater than 70% by mass, still more preferably, equal to or greater than 80% by mass.

In the present embodiment, the transition layer 62 is stacked between the base material 60 and the titanium metal layer 66. In the present embodiment, when the titanium metal layer 66 is formed on the base material 60 by physical vapor deposition (PVD), for example, the transition layer 62 is formed along with the titanium metal layer 66. For this reason, the transition layer 62 contains a component derived from the base material 60 and a component derived from the titanium metal layer 66. More specifically, the transition layer 62 contains a composite oxide of chromium (Cr) and titanium (Ti), or a composite oxide of iron (Fe) and Ti, for example.

The carbon layer 70 is stacked on an opposite side to the base material 60 with respect to the titanium metal layer 66 in the stacking direction d1. More specifically, the carbon layer 70 is stacked on the upper side with respect to the titanium metal layer 66 and next to the titanium metal layer 66. The carbon layer 70 contains carbon (C) as a major element. The major element means an element contained in a material, member or the like at an atomic ratio equal to or greater than 50% (50 at.%). More specifically, the first carbon layer 71 and the second carbon layer 72 both contain C as major elements. Arranging the described carbon layer 70 containing C as the major element on the upper side with respect to the titanium metal layer 66 makes it possible to improve the electrical conductivity of the separator 40. The content of an element in each of the first carbon layer 71 and the second carbon layer 72 may be examined by secondary ion mass spectrometry (SIMS).

The second carbon layer 72 is stacked on the opposite side to the base material 60 with respect to the first carbon layer 71 in the stacking direction d1. More specifically, the second carbon layer 72 is stacked on the upper side with respect to the first carbon layer 71 and next to the first carbon layer 71. The second carbon layer 72 corresponds to an uppermost layer in the separator 40, and forms a part in a most superficial layer of the separator 40 in the stacking direction d1.

The second carbon layer 72 contains at least one type of element from hydrogen (H), nitrogen (N), and oxygen (O) as a minor element in addition to C as the major element. In the present embodiment, the second carbon layer 72 has a content of the minor element equal to or greater than 5 at.% and equal to or less than 30 at.%. Specifically, the second carbon layer 72 contains H, N, and O at a total atomic ratio equal to or greater than 5 at.% and equal to or less than 30 at.%. The minor element in the second carbon layer 72 exists as a compound of C, for example. As described above, the content of a minor component in the second carbon layer 72 may be examined by secondary ion mass spectrometry (SIMS).

The present inventors have found that providing the minor component in the second carbon layer 72 achieves improvement of barrier performance of the second carbon layer 72, compared to a case where the second carbon layer 72 does not contain a minor component. The barrier performance mentioned herein means barrier performance against liquid, more specifically, against the generated water. The minor component existing as a compound of C in the second carbon layer 72 is considered to improve the barrier performance of the second carbon layer 72. Improving the barrier performance of the second carbon layer 72 in this way allows the second carbon layer 72 to function as a barrier layer for suppressing penetration of the generated water described above into the carbon layer 70. Causing the second carbon layer 72 to function as the barrier layer also makes it possible to suppress penetration of the generated water into a lower layer with respect to the carbon layer 70. The present inventors have found that setting the content of the minor component in the second carbon layer 72 equal to or greater than 5 at.% makes it possible to improve the barrier performance of the second carbon layer 72 further. The present inventors have further found that setting the content of the minor component in the second carbon layer 72 equal to or less than 30 at.% makes it possible to favorably suppress degradation in the electrical conductivity of the separator 40 resulting from reduction in the content of C in the second carbon layer 72. It is particularly preferable that the content of the minor component in the second carbon layer 72 be equal to or greater than 5 at.% and equal to or less than 30 at.%.

The present inventors have found that setting the thickness of the second carbon layer 72 in the stacking direction d1 equal to or less than 10 nm makes it possible to favorably suppress degradation in the electrical conductivity of the separator 40 resulting from increase in the thickness of the second carbon layer 72. From the viewpoint of causing the second carbon layer 72 to function as the barrier layer favorably while suppressing degradation in the electrical conductivity of the separator 40, it is particularly preferable that the thickness of the second carbon layer 72 be equal to or greater than 1 nm and equal to or less than 10 nm. The thicknesses of the layers in the separator 40 including the thickness of the second carbon layer 72 may be measured using sectional images of the layers observed under a transmission electron microscope (TEM), for example. More specifically, the thickness of one layer is measured as an average of thicknesses measured at five corresponding positions in the same layer.

In the present embodiment, the content of a minor element in the first carbon layer 71 is less than the content of the minor element in the second carbon layer 72. This allows the electrical conductivity of the carbon layer 70 to be improved further.

The titanium carbide layer 67 is stacked between the titanium metal layer 66 and the first carbon layer 71 in the stacking direction d1. Specifically, the titanium carbide layer 67 is arranged on the opposite side to the base material 60 with respect to the titanium metal layer 66 in the stacking direction d1. More specifically, the titanium carbide layer 67 is stacked on the upper side with respect to the titanium metal layer 66 and next to the titanium metal layer 66. The titanium carbide layer 67 contains titanium carbide (TiC) as a major component. When the carbon layer 70 is formed on the titanium metal layer 66 by PVD, for example, the titanium carbide layer 67 is formed along with the carbon layer 70.

The titanium oxide layer 68 is arranged between the titanium carbide layer 67 and the first carbon layer 71 in the stacking direction d1. More specifically, the titanium oxide layer 68 is stacked on the upper side with respect to the titanium carbide layer 67 and next the titanium carbide layer 67. The titanium oxide layer 68 is stacked on the lower side with respect to the carbon layer 70 and next to the carbon layer 70. The titanium oxide layer 68 contains titanium oxide (TiOx) as a major component. Here, TiOx includes titanium oxide (II), titanium trioxide (Ti₂O₃), and titanium dioxide (TiO₂). In other embodiments, the titanium oxide layer 68 may be omitted from the titanium-based layer 65, for example.

The present inventors have found that providing the titanium oxide layer 68 on the upper side with respect to the titanium carbide layer 67 allows the titanium oxide layer 68 to function as a protective layer for protecting the titanium-based layer 65 from oxidation resulting from the impurity derived from the electrolyte membrane. By causing the titanium oxide layer 68 to function as the protective layer in this way, even if the generated water reaches the titanium-based layer 65 via the carbon layer 70, it is still possible to suppress oxidation of the titanium-based layer 65 resulting from the impurity contained in the generated water and derived from the electrolyte membrane. In the titanium oxide layer 68, state change resulting from oxidation is less likely to occur than in the titanium carbide layer 67, and this is considered to cause the titanium oxide layer 68 to fulfill the function as the protective layer.

The present inventors have found that setting the thickness of the titanium oxide layer 68 equal to or greater than 1 nm allows the titanium oxide layer 68 to fulfill the function as the protective layer favorably. The present inventors have further found that setting the thickness of the titanium oxide layer 68 equal to or less than 15 nm makes it possible to favorably suppress degradation in the electrical conductivity of the separator 40 resulting from increase in the thickness of the titanium oxide layer 68. It is particularly preferable that the thickness of the titanium oxide layer 68 be equal to or greater than 1 nm and equal to or less than 15 nm.

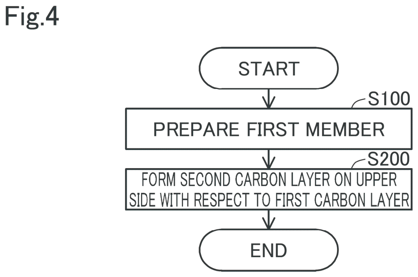

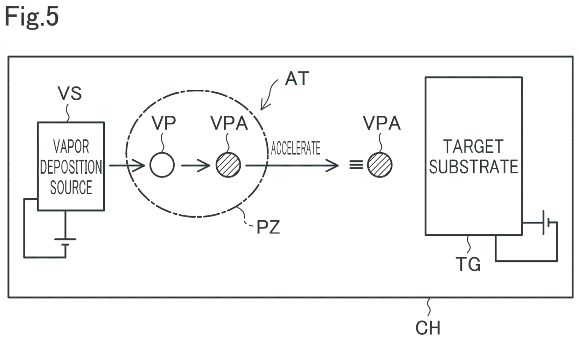

Fig. 4 is a flowchart showing a method of manufacturing the separator 40 according to the present embodiment. Fig. 5 is a view explaining the method of manufacturing the separator 40. In step S100, a preparatory step is performed. The preparatory step is a step of preparing a first member 101 shown in Fig. 3. The first member 101 is a stack including at least the base material 60, the titanium metal layer 66, and the first carbon layer 71 stacked on each other. The first member 101 corresponds to a stacked structure in a state where the second carbon layer 72 is not formed, and does not include the second carbon layer 72. In the present embodiment, the first member 101 includes the base material 60, the transition layer 62, the titanium metal layer 66, the titanium carbide layer 67, the titanium oxide layer 68, and the first carbon layer 71. The preparatory step of the present embodiment will be described later in detail.

In step S200 in Fig. 4, a forming step is performed. As shown in Fig. 5, the forming step is a step of forming the second carbon layer 72 on the upper side with respect to the first carbon layer 71 in the first member 101 by ion plating as one type of PVD. More specifically, in the forming step, vapor is generated from a vapor deposition source VS in a chamber CH of a vapor deposition device using an electron gun. Vapor-deposited particles VP in the vapor are ionized in plasma PZ under a predetermined atmosphere AT to generate vapor-deposited particle ions VPA. The vapor-deposited particle ions VPA are applied toward a target substrate TG while being accelerated, thereby forming a vapor-deposited film on a surface of the target substrate TG. The vapor-deposited particle ions VPA are accelerated by a negative bias voltage applied to the target substrate TG. In the forming step, a substance containing C is used as the vapor deposition source VS. The first member 101 is used as the target substrate TG in the forming step. The predetermined atmosphere AT corresponds to an atmosphere for ionizing the vapor deposition source VS.

In the forming step in step S200, an additive element including at least one type from H, N, and O is provided in at least one of the vapor deposition source VS and the predetermined atmosphere AT. In the forming step of the present embodiment, in addition to argon gas conventionally used, gas such as acetylene gas or nitrogen gas, for example, is added to the predetermined atmosphere AT. This allows particles containing C and the additive element to be applied to the first carbon layer 71 as the target substrate TG in the forming step, making it possible to form the second carbon layer 72 containing the minor component on the upper side with respect to the first carbon layer 71. In other embodiments, hydrocarbon-based gas (CxHy), hydrogen gas, or oxygen gas other than acetylene gas may be introduced into the predetermined atmosphere AT, for example. Various types of substances containing C and the additive element may be used as the vapor deposition source VS.

The amount of the additive element contained in the vapor deposition source VS or the predetermined atmosphere AT is adjusted in such a way that the content of the minor element in the second carbon layer 72 of the separator 40 to be manufactured becomes equal to or greater than 5% and equal to or less than 30%. For example, the content of the minor element in the second carbon layer 72 may be increased by increasing the amount of the additive element to be contained in the vapor deposition source VS or the predetermined atmosphere AT.

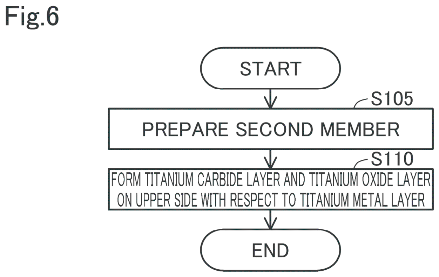

Fig. 6 is a flowchart of a preparatory step according to the present embodiment. In step S105, a second member 102 shown in Fig. 3 is prepared. The second member 102 is a stack including the base material 60, the transition layer 62, and the titanium metal layer 66. The second member 102 corresponds to a stacked structure in a state where the titanium carbide layer 67 and the layers on the upper side with respect to the titanium carbide layer 67 are not formed, and does not include the titanium carbide layer 67, the titanium oxide layer 68, and the carbon layer 70.

In step S110, the titanium carbide layer 67 and the titanium oxide layer 68 are formed on the upper side with respect to the titanium metal layer 66 in the second member 102. More specifically, in step S110, the titanium oxide layer 68 is formed by ion plating, like in step S200 of Fig. 4. In step S110, a substance containing C is used as the vapor deposition source VS. In step S110, the second member 102 is used as the target substrate TG.

In step S110, O is provided in at least one of the vapor deposition source VS and the predetermined atmosphere AT. This allows particles containing C and O to be applied to the titanium metal layer 66 as the target substrate TG in step S110. In doing this, carbon ions derived from C as an element lighter than O are accelerated, thereby preferentially applying the carbon ions to the titanium metal layer 66. This binds the carbon ions to Ti in the titanium metal layer 66 preferentially compared to oxygen ions. As a result, it becomes possible to form the titanium carbide layer 67 on the upper side with respect to the titanium metal layer 66 and form the titanium oxide layer 68 on the upper side with respect to the titanium carbide layer 67. In addition to argon gas conventionally used, various types of gas containing O such as oxygen gas, for example, may be added to the predetermined atmosphere AT in step S110. Various types of substances containing C and O may be used as the vapor deposition source VS in step S110.

In other embodiments, the second carbon layer 72 may be formed by a process different from ion plating or by a process different from PVD. At least one of the titanium carbide layer 67 and the titanium oxide layer 68 may be formed by a process different from ion plating or by a process different from PVD. In the preparatory step, the first member 101 produced previously may be prepared.

According to the separator 40 of the present embodiment described above, the carbon layer 70 includes the second carbon layer 72 provided on the upper side with respect to the first carbon layer 71 and containing at least one type from H, N, and O as the minor element. By providing the second carbon layer 72 with at least one type from H, N, and O as the minor element in this way, it becomes possible for the second carbon layer 72 to function as the barrier layer for suppressing penetration of the generated water containing the impurity derived from the electrolyte membrane into the carbon layer 70. In a conventional separator, the carbon layer stacked on the base material might be deteriorated by touching the generated water containing the impurity derived from the electrolyte membrane described above, and this might cause peeling of the carbon layer. Such peeling of the carbon layer might degrade the electrical conductivity of the separator 40. By contrast, in the present embodiment, with the presence of the second carbon layer 72 functioning as the barrier layer, it is possible to reduce the occurrence of peeling of the carbon layer 70 resulting from the impurity derived from the electrolyte membrane.

In the present embodiment, the content of the minor element in the second carbon layer 72 is equal to or greater than 5 at.% and equal to or less than 30 at.%. This makes it possible to effectively suppress degradation in the electrical conductivity of the second carbon layer 72 resulting from the minor element while the second carbon layer 72 is caused to fulfill the function as the protective layer effectively. In other embodiments, the content of the minor element in the second carbon layer 72 may be less than 5 at.% or greater than 30 at.%.

In the present embodiment, the separator 40 includes the titanium carbide layer 67 stacked between the titanium metal layer 66 and the first carbon layer 71, and the titanium oxide layer 68 stacked between the titanium carbide layer 67 and the first carbon layer 71. This allows the titanium oxide layer 68 to function as the protective layer for protecting the titanium-based layer 65 from oxidation resulting from the impurity derived from the electrolyte membrane. Thus, it is possible to suppress oxidation of the titanium-based layer 65, particularly, oxidation of the titanium carbide layer 67 resulting from the impurity. In a conventional separator without the titanium oxide layer 68, a titanium carbide layer might be oxidized by touching generated water having reached the titanium carbide layer via a carbon layer. Such oxidation of the titanium carbide layer might degrade binding property between Ti in the titanium carbide layer and C in the carbon layer, and this might cause peeling of the carbon layer. By contrast, in the present embodiment, the titanium oxide layer 68 functioning as the protective layer allows oxidation of the titanium-based layer 65 to be suppressed. Thus, it is possible to reduce the occurrence of degradation in binding property between Ti in the titanium-based layer 65 and C in the carbon layer 70. As a result, it is possible to reduce the occurrence of peeling of the carbon layer 70 more effectively.

In the present embodiment, the thickness of the titanium oxide layer 68 is equal to or greater than 1 nm and equal to or less than 15 nm. This makes it possible to suppress degradation in the electrical conductivity of the separator 40 resulting from increase in the thickness of the titanium oxide layer 68 while causing the titanium oxide layer 68 to fulfill the function as the protective layer favorably.

In the present embodiment, the thickness of the second carbon layer 72 is equal to or greater than 1 nm and equal to or less than 10 nm. This makes it possible to suppress degradation in the electrical conductivity of the separator 40 resulting from increase in the thickness of the second carbon layer 72 while causing the second carbon layer 72 to fulfill the function as the barrier layer favorably.

The present disclosure is not limited to the embodiments described above and is able to be realized with various configurations without departing from the spirit thereof. For example, technical features in the embodiments corresponding to the technical features in the aspects described in the section of SUMMARY are able to be replaced with each other or combined together, as appropriate, in order to solve part or the whole of the problems described previously or to achieve part or the whole of the effects described previously. When the technical features are not described as essential features in the present specification, they are able to be deleted, as appropriate.

## Claims

1. A separator (40) for a fuel cell (10) comprising:
a metallic base material (60);
a titanium-based layer (65) stacked in a stacking direction with respect to the base material (60); and
a carbon layer stacked on an opposite side to the base material (60) with respect to the titanium-based layer (65) in the stacking direction, wherein
the titanium-based layer (65) includes a titanium metal layer (66), and
the carbon layer includes:
a first carbon layer (71); and
a second carbon layer (72) stacked on the opposite side to the base material (60) with respect to the first carbon layer (71) in the stacking direction, the second carbon layer (72) containing at least one type from a hydrogen element, a nitrogen element, and an oxygen element as a minor element.

2. The separator (40) according to claim 1, wherein
the second carbon layer (72) has a content of the minor element equal to or greater than 5 at.% and equal to or less than 30 at.%.

3. The separator (40) according to claim 1 or 2, wherein
the titanium-based layer (65) further includes:
a titanium carbide layer (67) stacked between the titanium metal layer (66) and the first carbon layer (71) in the stacking direction; and
a titanium oxide layer (68) stacked between the titanium carbide layer (67) and the first carbon layer (71) in the stacking direction.

4. The separator (40) according to claim 3, wherein
the titanium oxide layer (68) has a thickness equal to or greater than 1 nm and equal to or less than 15 nm.

5. A method of manufacturing a separator (40) for a fuel cell (10), comprising:
a preparatory step of preparing a stack including a metallic base material (60), a titanium-based layer (65), and a first carbon layer (71), the titanium-based layer (65) being stacked in a stacking direction with respect to the base material (60) and including a titanium metal layer (66), the first carbon layer (71) being stacked on an opposite side to the base material (60) with respect to the titanium-based layer (65) in the stacking direction; and
a forming step of forming a second carbon layer (72) on the opposite side to the base material (60) with respect to the first carbon layer (71) in the stacking direction by ion plating using a vapor deposition source (VS) containing a carbon element, the second carbon layer (72) containing at least one type from a hydrogen element, a nitrogen element, and an oxygen element as a minor element, wherein
in the forming step, at least one type from the hydrogen element, the nitrogen element, and the oxygen element is provided in at least one of the vapor deposition source (VS) and an atmosphere (AT) for ionizing the vapor deposition source (VS).
